(19) Europäisches Patentamt
European Patent Office
Office européen des brevets

(11) **EP 2 889 954 B1**

(12) **FASCICULE DE BREVET EUROPEEN**

(45) Date de publication et mention
de la délivrance du brevet:
**18.09.2019 Bulletin 2019/38**

(51) Int Cl.:
*H01Q 1/28* *(2006.01)* *H01Q 19/06* *(2006.01)*
*H01Q 19/18* *(2006.01)* *H01Q 19/19* *(2006.01)*
*H01Q 21/08* *(2006.01)* *G06F 17/50* *(2006.01)*

(21) Numéro de dépôt: **14199874.0**

(22) Date de dépôt: **22.12.2014**

(54) **Procédé pour définir la structure d'une antenne en bande Ka**

Verfahren zur Definition einer Struktur einer Ka-Band-Antenne

Method for defining the structure of a Ka-band antenna

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **23.12.2013 FR 1303066**

(43) Date de publication de la demande:
**01.07.2015 Bulletin 2015/27**

(73) Titulaire: **THALES**
**92400 Courbevoie (FR)**

(72) Inventeurs:
• **Boutigny, Pierre**
**92622 GENNEVILLIERS Cedex (FR)**
• **Collin, Laurent**
**92622 GENNEVILLIERS Cedex (FR)**
• **Beguet, Laurent**
**92622 GENNEVILLIERS Cedex (FR)**

(74) Mandataire: **Dudouit, Isabelle et al
Marks & Clerk France
Conseils en Propriété Industrielle
Immeuble " Visium "
22, avenue Aristide Briand
94117 Arcueil Cedex (FR)**

(56) Documents cités:
CA-A- 385 262     US-A1- 2002 113 744
US-B1- 6 268 835     US-B2- 6 563 473

• **STRICKLAND P C ED - INSTITUTE OF
ELECTRICAL AND ELECTRONICS ENGINEERS:
"Contiguous paraboloid arrays for mobile
satellite communications", 2002 DIGEST, IEEE
ANTENNAS AND PROPAGATION SOCIETY
INTERNATIONAL SYMPOSIUM : JUNE 16 - 21,
2002, SAN ANTONIO, TEXAS; [IEEE ANTENNAS
AND PROPAGATION SOCIETY INTERNATIONAL
SYMPOSIUM], IEEE OPERATIONS CENTER,
PISCATAWAY, NJ, vol. 4, 16 juin 2002
(2002-06-16), pages 724-727, XP010592527, DOI:
10.1109/APS.2002.1017085 ISBN:
978-0-7803-7330-3**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

L'objet de l'invention concerne un procédé pour définir la structure, les dimensions, la géométrie d'une antenne multi foyers plane fonctionnant dans la bande Ka, de faible hauteur correspondante permettant son installation sous un radôme sur un porteur, par exemple. L'invention est notamment utilisée pour la définition d'antennes fonctionnant dans la bande Ka en utilisant plusieurs sources de grande taille, supérieures à la longueur d'onde, et disposées dans un radôme. L'antenne et son positionneur sont disposés, par exemple, sous un radôme installé sur un avion de type gros porteur où la hauteur de radôme est en général limitée à 30 cm.

La bande Ka est en cours de déploiement pour les communications par satellite à haut débit. Elle est caractérisée par une fréquence très élevée, induisant des difficultés de réalisation technologique, un écart des fréquences en émission Tx, environ 20 GHz, et en réception Rx, environ 30 GHZ, très important, une largeur de bande utilisable importante de l'ordre de 2 GHz. De nombreux industriels développent des systèmes antennaires compatibles d'applications mobiles, soit terrestres, soit aéronautiques.

L'utilisation de paraboles dans les systèmes de communication ne convient pas pour les mobiles car leur hauteur est excessive, ce qui provoque des contraintes dans les déplacements, des impossibilités d'utilisation lorsque ces systèmes deviennent hors gabarit, etc. D'autre part, dans le domaine des communications par satellite à haut débit, l'environnement normatif est important. La densité de puissance émise hors de l'axe est réglementée afin d'éviter le brouillage d'autres satellites. Ceci impose à l'antenne d'avoir un diagramme avec des lobes secondaires ou de réseau bas.

La plupart des solutions développées par l'art antérieur sont imparfaites et présentent en général des remontées de lobes secondaires dans certaines directions. Ces solutions sont basées sur des réseaux denses de sources, mais la fréquence très élevée en bande Ka, émission 30 GHz, impose des compromis en termes de densité des sources. Une des solutions offertes est basée sur un réseau en quinconce plus facile à construire mais qui présente d'importants lobes de réseau.

Dans l'art antérieur connu du demandeur, les antennes utilisées fonctionnent dans la bande Ku. En bande Ku, deux types de solutions sont utilisées pour réaliser de telles antennes.

Un premier type est le type A, tel que décrit dans la demande de brevet US 2011/0267250 où les réseaux denses de sources élémentaires sont de type cornet ou fente. Le deuxième type de solution est le type B où les réseaux sont basés sur des sources de grande taille, par exemple selon le brevet US 6 563 473. Pour éviter la présence de lobes de réseau, la distance entre sources élémentaires doit être inférieure à la longueur d'onde, par exemple 1cm en bande Ka. Cette condition est suffisante mais pas nécessaire. Il faut généralement, de plus, que la densité de puissance sur toute la surface de l'ouverture de l'antenne corresponde à des lois mathématiques précises et l'on peut utiliser pour cela, par exemple, une loi uniforme qui ne donnera pas de lobes de réseau.

Les solutions de type A sont d'applications complexes et coûteuses en bande Ka car :

- le pas de réseau de 1cm laisse très peu de place pour réaliser les fonctions,
- le nombre de sources est très élevé (1408) pour une antenne typique de 22cm par 64cm,
- l'écart de 10GHz entre fréquence TX et RX ainsi que la largeur de bande de 2GHz imposent des solutions à très large bande (bande relative de 30%).

Les solutions de type B sont plus simples à réaliser car elles comportent moins de sources. Comme l'écartement entre sources est supérieur à la longueur d'onde, la présence de lobes de réseau est généralement admise.

Le brevet US 6 563 473 décrit un système antennaire travaillant dans la bande Ku dont la bande fréquence est deux fois plus basse et où l'écartement entre sources est irrégulier pour deux ou plus de deux sources.

La demande de brevet US 2011/0267250 présente une solution qui consiste à rapprocher les sources en tronquant les réflecteurs de manière asymétrique. Cette solution fonctionne avec deux sources.

Le document de Strickland intitulé « contiguous paraboloid arrays for mobile satellite communications », 2002 DIGEST, IEEE Antennas and Propagation Society International Symposium, June 16-21, 2002, XP010592527, divulgue une antenne à deux éléments pour la fonction « full duplex » et une antenne à quatre éléments pour laquelle les lobes secondaires ne sont pas maîtrisés. Ce document indique que la version « half duplex » a des lobes secondaires à -10 dB, la conception de l'antenne n'étant pas maîtrisée. D'autre part, la bande Ku de fonctionnement pour cette antenne est plus facile à gérer en mode « full-duplex ».

Le brevet CA 385262 décrit la mise en phase d'un réseau d'antennes ainsi que la possibilité de dépointer légèrement le faisceau en ajustant les phases d'excitation des éléments. Il est aussi indiqué l'espacement optimal entre antennes permettant de limiter les lobes de réseau. Il n'y a aucune indication sur le type d'antenne élémentaire à utiliser ainsi que sur son optimisation pour obtenir un gain « Gseuil » ainsi qu'une forme de réflecteur permettant de limiter l'amplitude des lobes secondaires.

Le brevet US 6268835 décrit un réseau de réflecteurs (2D) contrôlés en phase/amplitude afin de pouvoir ajuster légèrement la direction du faisceau. Aucune optimisation de la forme des réflecteurs n'est décrite.

L'art antérieur connu du demandeur ne décrit pas d'antenne à faibles lobes possédant plus de deux sources.

Un des objectifs de la présente invention est de fournir une antenne de type B précitée à faible lobes secondaires possédant au moins deux sources, dans laquelle les sources sont réparties de manière régulière et les réflecteurs ont des formes adaptées, obtenues par la mise en oeuvre d'un algorithme spécifique, les réflecteurs étant éclairés par des sources constituées d'une seule pièce. L'antenne obtenue offrira un gain proche de zéro dans la direction des lobes de réseau, ainsi ceux-ci seront aussi bas que possible.

L'objet concerne un procédé pour déterminer la géométrie d'une antenne réseau multi foyers plane pour la bande Ka comprenant au moins deux éléments antennaires, chaque élément antennaire comprenant un réflecteur et un sous-réflecteur, au moins une source alimentant lesdits éléments antennaires, le procédé est caractérisé en ce qu'il comporte au moins les étapes suivantes :

- définir une valeur seuil $G_{seuil}$ de gain de l'antenne,
- représenter la surface du sous-réflecteur et la surface du réflecteur par un ensemble de points $(X_S, Z_S)$ pour le sous-réflecteur et $(X_{SR}, Z_{SR})$ pour le réflecteur,
- générer à partir d'un module de simulation électromagnétique adapté un ensemble de couples de valeurs $\{(\theta_1, G_1)......(\theta_n, G_n)\}$ correspondant à la direction du rayonnement et au gain de l'antenne, pour chaque élément antennaire et pour chaque ensemble de points choisis pour représenter la surface du sous-réflecteur et du réflecteur selon une position de la source,
- déterminer pour chaque couple de valeurs et du diagramme d'une source élémentaire considérée, la valeur du gain maximal de l'antenne dans la direction des lobes de réseau,
- comparer la valeur du gain maximal obtenue, et si cette valeur est supérieure à une valeur seuil, alors faire varier au moins un des paramètres $(X_{SR}, Z_{SR})$ pour le sous-réflecteur et $(X_R, Z_R)$ pour le réflecteur,
- déterminer la forme de l'antenne à partir des points vérifiant les valeurs seuils.

Selon une variante de réalisation, on utilise un réflecteur ayant une révolution autour d'un axe z pour définir les points vérifiant les valeurs seuils et définissant l'antenne, puis on exécute une étape dans laquelle on tronque les réflecteurs à une largeur correspondant à la distance entre deux sources considérées selon un axe y.

Le procédé peut aussi comporter les étapes suivantes, on positionne quatre alimentations sur une pièce contenant le réflecteur principal multi foyers, quatre sous réflecteurs fixés à chaque alimentation au moyen d'une pièce de maintien, deux combineurs alimentant en polarisation circulaire droite ou circulaire gauche un accès 20/30 GHz en polarisation LHCP, un accès 20/30 GHz en polarisation RHCP et un filtre diplexeur par accès afin d'obtenir deux accès émission Tx pour deux polarisations.

Selon un mode de réalisation, on tronque à une largeur D correspondant à la distance entre deux sources considérées selon un axe y les réflecteurs de révolution autour d'un axe z.

D'autres caractéristiques et avantages du dispositif selon l'invention apparaîtront mieux à la lecture de la description qui suit d'un exemple de réalisation donné à titre illustratif et nullement limitatif annexé des figures qui représentent :

- la figure 1, une représentation de la formation de lobes de réseau,
- la figure 2, un exemple donné pour une antenne à quatre éléments,
- la figure 3, une vue de l'antenne de la figure 2,
- la figure 4, une représentation de points de contrôle pour la définition du sous-réflecteur,
- la figure 5, une définition d'une source élémentaire après l'exécution du procédé selon l'invention,
- les figures 6 et 7, le diagramme d'émission obtenue dans le plan H et le plan V,

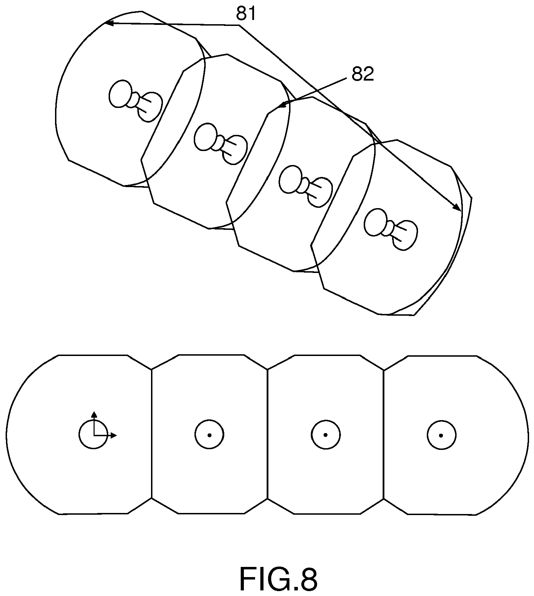

- la figure 8, une variante de réalisation de l'antenne de la figure 2,
- la figure 9 et la figure 10, un schéma montrant la connexion des éléments antennaires.

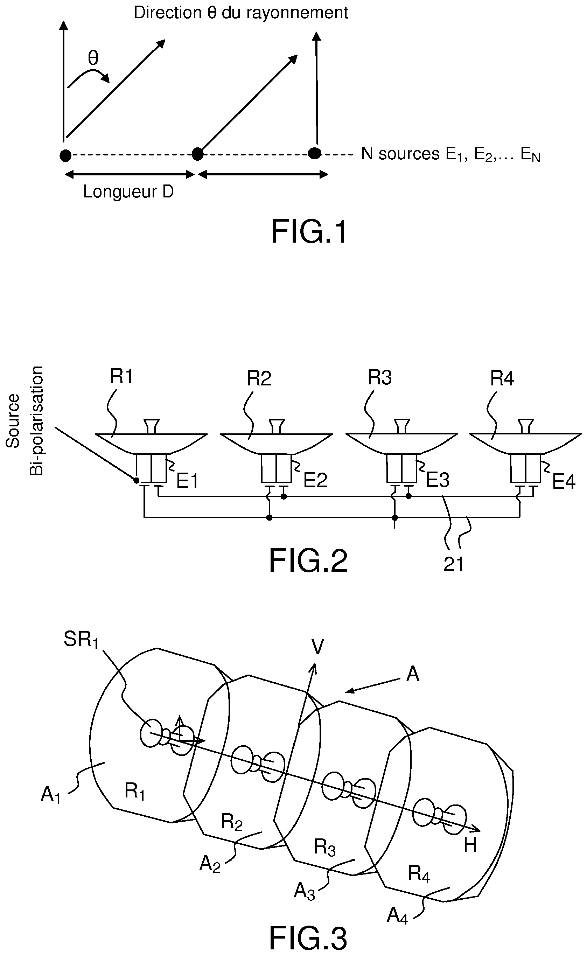

Afin de mieux faire comprendre l'objet de l'invention, la description détaillée est donnée dans le cas d'une antenne comprenant quatre éléments sources. La figure 1 schématise la direction θ du rayonnement d'une source dans un réseau de N sources Ei espacées d'une distance D. Un tel réseau va générer des lobes de réseau dont les positions angulaires sont données par :

$$\sin(\theta) = N \frac{\lambda}{D}$$

N:entier>0
λ:longueur d'onde

D:distance entre sources

Par exemple, pour une fréquence G=30 GHz et une distance D de 16 cm, les premiers lobes de réseau sont des multiples de 3,6°. L'amplitude de ces lobes est déterminée par le gain d'une source élémentaire dans la direction du lobe de réseau, c'est-à-dire dans les directions 3.6°, 7.2°, 10.8° dans cet exemple de réalisation.

La figure 2 et la figure 3 schématisent un exemple de système antennaire A comprenant quatre éléments $A_1$, $A_2$, $A_3$, $A_4$. Un élément Ai est constitué notamment d'une source Ei, d'un réflecteur Ri d'onde qui va éclairer un satellite à l'infini, d'un sous-réflecteur SRi dont la fonction est d'éclairer le réflecteur.

Les éléments antennaires Ai sont, par exemple, constituées d'antennes à réflecteurs Ri dont la partie excitation est formée d'un élément rayonnant Ei bipolarisation en polarisation circulaire gauche ou LHCP pour left hand circular polarization et polarisation circulaire droite ou RHCP pour right hand circular polarization à deux accès, comme représenté sur la figure 2.

Chaque ensemble d'accès de même polarisation est connecté, par exemple, par un distributeur 21 en guide d'onde pour former l'accès général de l'antenne A. Ainsi il y a deux accès principaux: un accès polarisation gauche LHCP et un accès polarisation droite RHCP.

Le procédé selon l'invention a notamment pour objectif de générer une géométrie d'antenne et son antenne de dimensions définies qui va permettre d'obtenir un gain G proche de 0 dans la direction des lobes de réseau. Le gain de la source sera diminué dans les directions souhaitées.

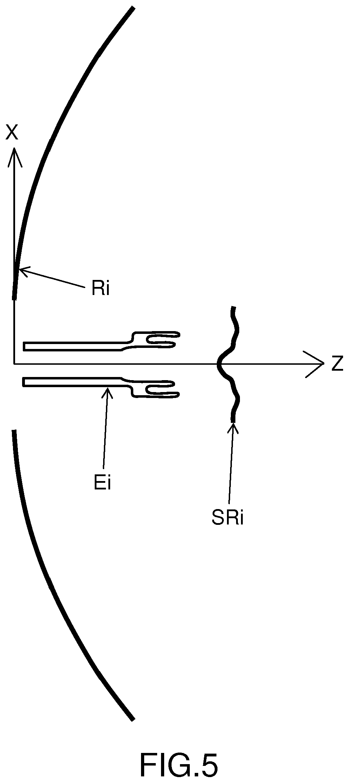

On va représenter la géométrie des surfaces d'un élément antennaire Ai par des couples de point dans un diagramme X, Z (figure 5).

Une source Ei est définie par un point élémentaire P. On définit un ensemble de points ($X_{SR}$, $Z_{SR}$) dits points de contrôle pour un sous-réflecteur SR et un ensemble de points ($X_R$, $Z_R$) de contrôle pour un réflecteur R.

On injecte ces points choisis dans un logiciel de simulation électromagnétique afin d'obtenir un fichier contenant des couples de valeurs (θ, G), correspondant à la direction du rayonnement et au gain de l'antenne On obtient un ensemble de couples {($θ_1$, $G_1$)...... ($θ_n$, $G_n$)} pour chaque couple de l'ensemble de points sélectionnés, ceci pour les points de contrôle relatifs au sous-réflecteur et pour les points de contrôle pour les réflecteurs.

En fonction de l'angle de visée et du diagramme de la source élémentaire, on va rechercher le gain maximum possible. Pour cela, on utilise un logiciel adapté à déterminer la position des points de modélisation précités permettant d'annuler le gain de la source dans les directions souhaitées. On cherche à optimiser le diagramme de rayonnement d'une source afin que le gain de la source soit faible dans les directions des lobes de réseau. Pour cela, on va optimiser la position de chaque point fixé préalablement pour définir la forme du sous-réflecteur et la forme du réflecteur pour une position P donnée de la source.

En fonction d'un angle θ de visée, on connait le diagramme de rayonnement de la source élémentaire. On calcule le gain maximum de la source, on le compare à une valeur seuil $G_{seuil}$ et si le gain dépasse cette valeur seuil, alors on fait varier l'un des paramètres ($X_{SR}$, $Z_{SR}$) pour le sous-réflecteur et/ou ($X_R$, $Z_R$) pour le réflecteur.

Les lobes secondaires seront présents mais faibles car le gain de chaque source élémentaire sera faible dans la direction considérée.

Dans l'exemple donné, les variables optimisées sont :

| zhorn | Position du cornet ou source |
|---|---|
| $Z_{SR1}..Z_{SR7}$ | 7 points de contrôle en Z pour le sous-réflecteur |
| $Z_{R1}..Z_{R4}$ | 4 points de contrôle en Z pour le réflecteur principal |

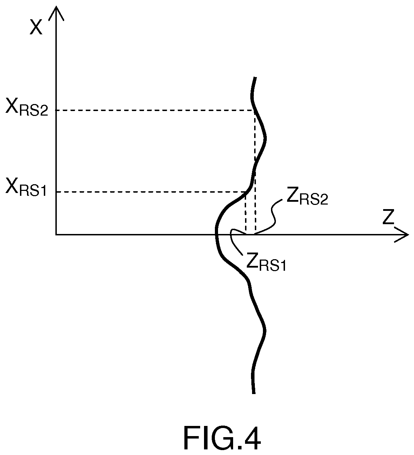

Les réflecteurs sont de révolution autour de l'axe z, puis tronqués à la largeur D (distance entre deux sources) sur l'axe y. On obtient ainsi après optimisation de la géométrie d'un élément d'antenne, des formes pour les réflecteurs et les sous-réflecteurs, qui s'éloignent notablement des géométries conventionnelles, notamment celle du sous réflecteur qui présente des ondulations marquées représentées sur la figure 5 pour les points de contrôle choisis, selon la figure 4.

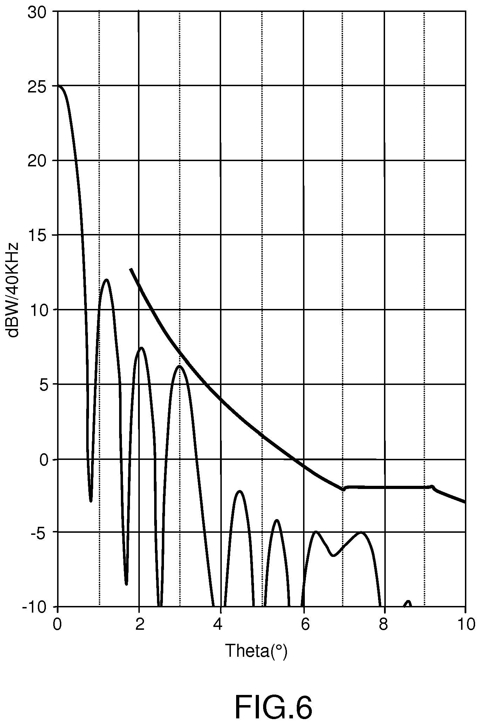

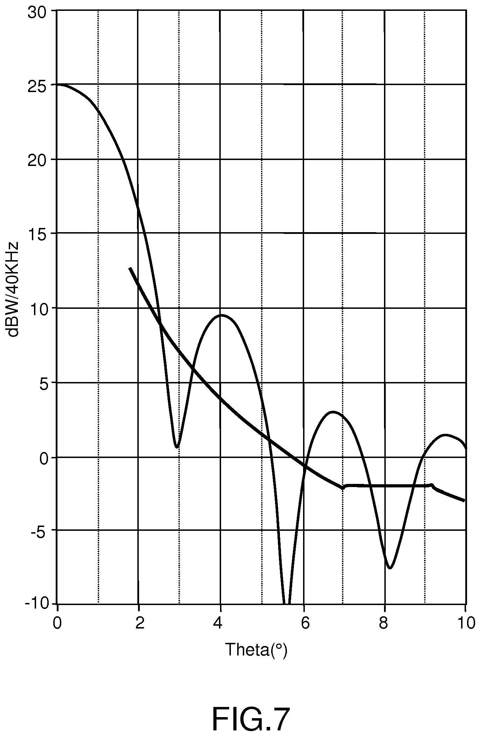

Les figures 6 et 7 montrent les résultats obtenus pour une antenne de quatre sources ou éléments antennaires de taille globale de 64cm (plan H) par 22cm (plan V). On remarque que les lobes de réseau n'apparaissent pas dans le plan H. Dans le plan V le diagramme est plus large car l'antenne est de plus faible taille (22cm).

A partir du diagramme obtenu pour le premier élément antennaire, on dérive les autres diagrammes pour les trois autres éléments antennaires.

On va ensuite vérifier que l'ensemble du système constitué des quatre éléments antennaires possède un gain qui est supérieur à une valeur de gain minimum Gmin pour un angle de visée de 0° dans l'axe de l'antenne, et inférieur à une valeur Ga pour un angle a donné, ceci pour plusieurs valeurs d'angle que l'on aura choisi à l'avance selon une méthode connue de l'homme du métier.

Selon une variante de réalisation, afin d'améliorer les performances de l'antenne, il est possible d'insérer des caches entre chaque source. Ceci permet d'éviter l'éclairement d'une source par une autre source et améliore les lobes diffus.

Selon une autre variante de réalisation la première source et la dernière source du réseau présentent des bords arrondis sur la partie qui n'est pas en contact avec les autres sources du réseau. Ceci permet notamment une pondération moins abrupte sur les bords et améliore le diagramme de rayonnement.

La source élémentaire de l'antenne étant de faible taille, dans certains cas, de l'ordre de 16 cm par 22 cm, on utilisera une source des ondes, plus connue sous le terme anglo-saxon par « feed », de petite taille afin d'éclairer le réflecteur.

La source des ondes utilisée est, par exemple, réalisée en une seule pièce mécanique. Les fonctions de cette pièce sont notamment les suivantes: deux accès large bande 20 GHz et 30GHz pour deux polarisations circulaires, une lame de polarisation circulaire, un cornet corrugué permettant d'éclairer le sous-réflecteur, des fixations pour montage d'un support de sous-réflecteur et pour fixer le feed à l'arrière de l'antenne.

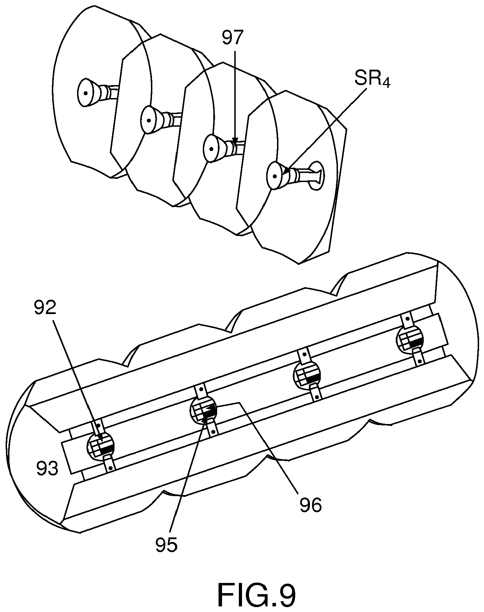

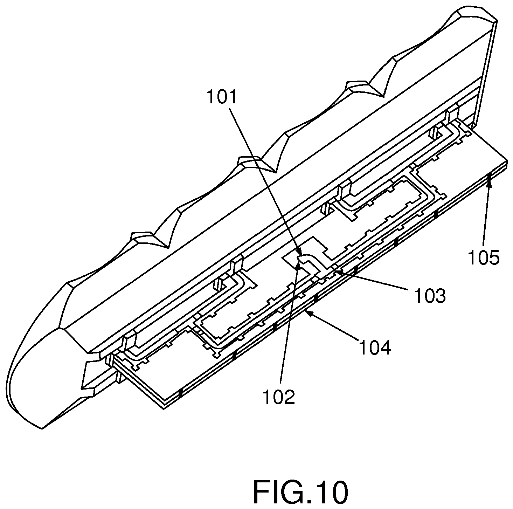

La figure 9 schématise un exemple d'assemblage de la partie rayonnante de l'antenne. L'antenne est obtenue dans cet exemple en assemblant quatre alimentations ou feed 92 sur une pièce 93 contenant le réflecteur principal multi-foyers 94. Les quatre sous-réflecteurs $SR_1$, SR2, $SR_3$, $SR_4$ sont fixés à chaque feed au moyen d'une pièce de maintien 97 en époxy, par exemple. On obtient sur la face arrière de l'antenne huit accès, soit quatre pour chaque polarisation. La figure 10 schématise la face arrière de l'antenne. Chaque groupe de quatre accès est relié, par exemple, par un combineur obtenu par usinage dans une plaque épaisse fermée par un capot 105 (figure 10) soudé. En utilisant deux combineurs 103, 104 pour alimenter en polarisation circulaire droite ou gauche, on obtient les deux accès principaux de l'antenne :

- un accès 20/30 GHz en polarisation LHCP, 96,
- un accès 20/30 GHz en polarisation RHCP, 95.

En utilisant deux filtres diplexeurs, un par accès, on peut finalement obtenir :
- deux accès émission Tx (20 GHz) pour deux polarisations,
- deux accès réception Rx (30 GHz) pour deux polarisations.

Le procédé et l'antenne obtenue par la mise en oeuvre du procédé présentent notamment les avantages suivants :

- une antenne à fable coût et large bande pour le projecteur d'ondes les réflecteurs étant facilement réalisables et le bloc d'alimentation monobloc réduit le coût d'assemblage,
- une émission et une réception simultanées,
- le choix des polarisations en émission et en réception,
- un fonctionnement dans la couverture Ka civile et militaire,
- une possibilité d'isoler le réflecteur multi-foyers par des caches.

**Revendications**

**1.** Procédé pour déterminer la géométrie d'une antenne réseau multi foyers plane pour la bande Ka comprenant au moins deux éléments antennaires, chaque élément antennaire comprenant un réflecteur et un sous-réflecteur, au moins une source alimentant lesdits éléments antennaires, le procédé est **caractérisé en ce qu'**il comporte au moins les étapes suivantes :

- définir une valeur seuil Gseuil de gain de l'antenne,
- représenter la surface du sous-réflecteur et la surface du réflecteur par un ensemble de points (($X_S$, $Z_S$) pour le sous-réflecteur et ($X_{SR}$, $Z_{SR}$) pour le réflecteur,
- générer à partir d'un module de simulation électromagnétique adapté un ensemble de couples de valeurs $\{(\theta_1, G_1)...... (\theta_n, G_n)\}$ correspondant à la direction du rayonnement et au gain de l'antenne, pour chaque élément antennaire et pour chaque ensemble de points choisis pour représenter la surface du sous-réflecteur et du réflecteur selon une position de la source,
- déterminer pour chaque couple de valeurs et du diagramme d'une source élémentaire considérée, la valeur du gain maximal de l'antenne dans la direction des lobes de réseau,
- comparer la valeur du gain maximal obtenue et si cette valeur est supérieure à une valeur seuil, alors faire varier au moins un des paramètres ($X_{SR}$, $Z_{SR}$) pour le sous-réflecteur et ($X_R$, $Z_R$) pour le réflecteur,
- déterminer la forme de l'antenne à partir des points vérifiant les valeurs seuils.

**2.** Procédé selon la revendication 1 **caractérisé en ce que** l'on utilise deux polarisations circulaires.

**3.** Procédé selon l'une des revendications 1 à 2 **caractérisé en ce que** l'on utilise un réflecteur ayant une révolution autour d'un axe z pour définir les points vérifiant les valeurs seuils et définissant l'antenne, puis on exécute une étape dans laquelle on tronque les réflecteurs à une largeur D correspondant à la distance entre deux sources considérées selon un axe y.

**4.** Procédé selon l'une des revendications 1 à 3 **caractérisé en ce qu'**il comporte les étapes suivantes: on positionne quatre alimentations (92) sur une pièce (93) contenant le réflecteur principal multi-foyers (94), quatre sous réflecteurs (SR1, SR2, SR3, SR4) fixés à chaque alimentation (92) au moyen d'une pièce de maintien (97), deux combineurs (103, 104) alimentant en polarisation circulaire droite ou circulaire gauche un accès 20/30 GHz en polarisation LHCP (96), un accès 20/30 GHz en polarisation RHCP (95) et un filtre diplexeur par accès afin d'obtenir deux accès émission Tx (20 GHz) pour deux polarisations.

**5.** Procédé selon la revendication 1 **caractérisé en ce que** les réflecteurs obtenus sont de révolution autour d'un axe z, et **en ce qu'**ils sont tronqués à une largeur D correspondant à la distance entre deux sources considérées selon un axe y.

**Patentansprüche**

**1.** Verfahren zum Bestimmen der Geometrie einer ebenen, multifunktionalen Netzwerkantenne für das Ka-Band, beinhaltend mindestens zwei Antennenelemente, wobei jedes Antennenelement einen Reflektor und einen Unterreflektor beinhaltet, wobei mindestens eine Quelle die Antennenelemente speist, wobei das Verfahren **dadurch gekennzeichnet ist, dass** es mindestens folgende Schritte beinhaltet:

• Definieren eines Schwellenwertes $G_{Schwelle}$ der Verstärkung der Antenne,
• Darstellen der Fläche des Unterreflektors und der Fläche des Reflektors durch eine Gruppe von Punkten ($X_s$, $Z_s$) für den Unterreflektor und ($X_{SR}$, $Z_{SR}$) für den Reflektor,
• Erzeugen, anhand eines geeigneten elektromagnetischen Simulationsmoduls, einer Gruppe von Wertepaaren $\{(\theta_1, G_1)...... (\theta_n, G_n)\}$, welche der Strahlungsrichtung und der Verstärkung der Antenne für jedes Antennenelement und für jede Gruppe von Punkten, welche gewählt werden, um die Fläche des Unterreflektors und des Reflektors entsprechend einer Position der Quelle darzustellen, entsprechen,
• Bestimmen, für jedes Wertepaar und das Diagramm einer betrachteten Elementarquelle, des Wertes der maximalen Verstärkung der Antenne in der Richtung der Netzwerk-Keulen,
• Vergleichen des erzielten Wertes der maximalen Verstärkung und wenn dieser Wert einen Schwellenwert überschreitet, in diesem Fall, Verändern von mindestens einem der Parameter ($X_{SR}$, $Z_{SR}$) für den Unterreflektor und ($X_R$, $Z_R$) für den Reflektor,
• Bestimmen der Form der Antenne anhand der Punkte, welche die Schwellenwerte bestätigen.

**2.** Verfahren nach Anspruch 1, **dadurch gekennzeichnet, dass** man zwei kreisförmige Polarisationen verwendet.

**3.** Verfahren nach einem der Ansprüche 1 bis 2, **dadurch gekennzeichnet, dass** ein Reflektor verwendet wird, welcher eine Umdrehung um eine z-Achse besitzt, um die Punkte zu bestimmen, welche die Schwellenwerte bestätigen und die Antenne definieren, wobei danach einen Schritt durchgeführt wird, bei welchem die Reflektoren bei einer Breite D trunkiert werden, welche dem Abstand zwischen zwei entlang einer y-Achse betrachteten Quellen entspricht.

**4.** Verfahren nach einem der Ansprüche 1 bis 3, **dadurch gekennzeichnet, dass** es folgende Schritte beinhaltet: vier Speisungen (92) werden auf einem Teil positioniert (93), welcher den multifokalen Hauptreflektor (94), vier Unterreflektoren (SR1, SR2, SR3, SR4), welche an jeder Speisung (92) mithilfe eines Halteteils (97) befestigt sind, zwei Kombinierer (103, 104), welche einen 20/30 GHz-Zugang mit kreisförmiger rechter oder kreisförmiger linker Polarisation mit einer LHCP-Polarisation (96) speisen, einen 20/30 GHz-Zugang mit RHCP-Polarisation (95) und einen Diplexer-Filter pro Zugang besitzt, um zwei Tx-Sendezugänge (20 GHz) für zwei Polarisationen zu erzielen.

**5.** Verfahren nach Anspruch 1, **dadurch gekennzeichnet, dass** die erzielten Reflektoren Reflektoren mit einer Umdrehung um eine z-Achse sind, und dadurch, dass sie bei einer Breite D, welche einem Abstand zwischen zwei entlang einer y-Achse betrachteten Quellen entspricht, trunkiert sind.

**Claims**

1. Method for determining the geometry of a planar multi-focus array antenna for the Ka band comprising at least two antenna elements, each antenna element comprising a reflector and a sub-reflector, at least one source powering said antenna elements, the method being **characterized in that** it comprises at least the following steps:

   • defining a threshold value $G_{seuil}$ of the antenna gain,
   • representing the surface of the sub-reflector and the surface of the reflector by a set of points $(X_S, Z_S)$ for the sub-reflector and $(X_{SR}, Z_{SR})$ for the reflector,
   • generating from a suitable electromagnetic simulation module a set of pairs of values $\{(\theta_1, G_1) ... (\theta_n, G_n)\}$ corresponding to the direction of the radiation and to the antenna gain for each antenna element and for each set of points chosen to represent the surface of the sub-reflector and of the reflector according to a position of the source,
   • determining for each pair of values and from the pattern of an elementary source under consideration, the value of the maximum antenna gain in the direction of the array lobes,
   • comparing the value of the maximum gain obtained, and if this value is above a threshold value, then varying at least one of the parameters $(X_{SR}, Z_{SR})$ for the sub-reflector and $(X_R, Z_R)$ for the reflector,
   • determining the shape of the antenna from the points verifying the threshold values.

2. Method according to claim 1, **characterized in that** two circular polarizations are used.

3. Method according to one of claims 1 to 2, **characterized in that** a reflector revolving about a z-axis is used to define the points verifying the threshold values and defining the antenna, then a step is executed in which the reflectors are shortened to a width D corresponding to the distance between two sources under consideration along a y-axis.

4. Method according to one of claims 1 to 3, **characterized in that** it comprises the following steps: four power supplies (92) are placed on a part (93) containing the main multi-focus reflector (94), four sub-reflectors (SR1, SR2, SR3, SR4) fastened to each power supply (92) by means of a holding part (97), two combiners (103, 104) powering with right-hand circular or left-hand circular polarization a 20/30 GHz port with LHCP polarization (96), a 20/30 GHz port with RHCP polarization (95) and one diplexing filter per port in order to obtain two emitting ports Tx (20 GHz) for two polarizations.

5. Method according to claim 1, **characterized in that** the reflectors obtained are revolving about a z-axis, and **in that** they are shortened to a width D corresponding to the distance between two sources under consideration along a y-axis.

Direction θ du rayonnement

FIG.1

Source Bi-polarisation

FIG.2

21

FIG.3

FIG.4

FIG.5

FIG.6

FIG.7

FIG.8

FIG.9

FIG.10

**EP 2 889 954 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20110267250 A
- US 6563473 B
- CA 385262
- US 6268835 B

**Littérature non-brevet citée dans la description**

- **STRICKLAND.** contiguous paraboloid arrays for mobile satellite communications. *2002 DIGEST, IEEE Antennas and Propagation Society International Symposium,* 16 Juin 2002